# EUROPÄISCHE PATENTSCHRIFT

(11) **EP 2 212 927 B1**
(45) Veröffentlichungstag und Bekanntmachung des Hinweises auf die Patenterteilung: **19.10.2011**
(21) Anmeldenummer: 08842554.1
(22) Anmeldetag: 21.10.2008
(51) Int. Cl.: H01L 31/18, H01L 21/368

(54) **VERFAHREN UND VORRICHTUNG ZUR BESCHICHTUNG EINES TRÄGERS FÜR DÜNNSCHICHTSOLARZELLEN**
METHOD AND DEVICE FOR COATING A CARRIER FOR THIN-FILM SOLAR CELLS
PROCÉDÉ ET DISPOSITIF DE REVÊTEMENT D'UN SUPPORT POUR CELLULES SOLAIRES À COUCHES MINCES

(30) Priorität: 22.10.2007 DE 102007052237
(43) Veröffentlichungstag der Anmeldung: 04.08.2010
(73) Patentinhaber: Gebr. Schmid GmbH, 72250 Freudenstadt (DE)
(72) Erfinder: SCHOCH, Martin, 72250 Freudenstadt-Kniebis (DE)
(74) Vertreter: Patentanwälte Ruff, Wilhelm, Beier, Dauster & Partner
(86) Internationale Anmeldenummer: PCT/EP2008/008877
(87) Internationale Veröffentlichungsnummer: WO 2009/053021

(56) Entgegenhaltungen:
- WO-A-2006/018013
- US-A1- 2002 043 278
- US-A1- 2006 024 960
- US-A1- 2007 020 400
- US-B1- 6 211 043
- BAOSHENG SANG ET AL: "Investigation of chemical-bath-deposited ZnS buffer layers for Cu(InGa)Se2 thin film solar cells" CONFERENCE RECORD OF THE 29TH IEEE PHOTOVOLTAIC SPECIALISTS CONFERENCE 20020519; 20020519 - 20020524 NEW YORK, NY : IEEE, US, Bd. CONF. 29, 19. Mai 2002 (2002-05-19), Seiten 632-635, XP010666379 ISBN: 978-0-7803-7471-3
- JOHNSTON D A ET AL: "Chemical bath deposition of zinc sulfide based buffer layers using low toxicity materials" THIN SOLID FILMS, ELSEVIER-SEQUOIA S.A. LAUSANNE, CH, Bd. 403-404, 1. Februar 2002 (2002-02-01), Seiten 102-106, XP004430335 ISSN: 0040-6090

## Beschreibung

Die Erfindung betrifft ein Verfahren zur Beschichtung eines Trägers bzw. Substrats für Dünnschichtsolarzellen mit Cadmiumsulfid auf eine Absorberschicht auf dem Träger sowie eine zur Durchführung dieses Verfahrens geeignete Vorrichtung bzw. Anlage.

Ein vielversprechender Zweig der Dünnschicht-Technologie für Dünnschichtsolarzellen basiert auf der Nutzung von Chalkopyrit-Verbindungen als Absorberschicht. Dabei handelt es sich um Kombinationen der Elemente Kupfer, Indium, Gallium, Schwefel und Selen. Diese Elemente können in verschiedenen stöchiometrischen Zusammensetzungen für die Photovoltaik passend dotiert werden. Am gebräuchlichsten sind die Verbindungen CulnSe₂ und CulnS₂, oder abgekürzt CIS bzw. CIGS.

Auf einem Trägersubstrat, z.B. einer Glasscheibe oder auch flexiblen Materialien wie Metall- oder Kunststofffolien, wird zuerst eine leitfähige Schicht abgeschieden. Für das Aufbringen der CIS-Absorberschicht sind verschiedene Verfahren im Einsatz, sie kann beispielsweise sequentiell mit anschließender Homogenisierung aufgebracht oder gleich in entsprechender Mischung aufgedampft werden. Alternativ zu CIS-Verbindungen kann auch Cadmiumtellurid als p-dotierte Absorberschicht eingesetzt werden.

Zur Erzeugung einer photoaktiven Halbleiterstruktur ist noch eine weitere n-dotierte Schicht auf der CIS-Absorberschicht erforderlich. Stand der Technik ist eine Beschichtung mit Cadmiumsulfid, die in einem nasschemischen Bad auf der CIS-Absorberschicht abgeschieden wird.

Zur Beschichtung der CIS/CdS-Absorberschicht wird eine Lösung mit einer Mischung aus Cadmiumacetat, Ammoniak und Thioharnstoff angesetzt. Die Abscheidereaktion startet bei einer Temperatur von etwa 50°C. Üblicherweise wird der Prozess bei 60°C gefahren. Die erforderliche Schichtdicke von 50 nm wird nach etwa 10 Minuten erreicht.

Die Reaktion in der Lösung ist nach etwa 20 Minuten beendet, das Cadmium fällt komplett als Cadmiumsulfid aus und kann nicht mehr zur Beschichtung verwendet werden. Bisher ist es noch nicht gelungen, diesen Prozess durch die Beimischung von zusätzlichen Chemikalien kontinuierlich zu betreiben, deshalb basieren die bekannten Prozesse alle auf einem Batch-Verfahren, d.h. die Substrate werden Stück für Stück in eine Beschichtungsanlage transportiert und dort mit einem möglichst kleinen Flüssigkeitsvolumen beschichtet und danach gespült und getrocknet. Die verbrauchte Reaktionslösung wird verworfen. Diese Batch-Verfahren sind für die Beschichtung von beispielsweise Folien, die üblicherweise von Rolle zu Rolle prozessiert werden, nur eingeschränkt geeignet.

Das Dokument US 2007/0020400 offenbart ein Verfahren zur Beschichtung eines Substrats für Dünnschichtsolarzellen mit Cadmiumsulfid mittels Aufprallen.

### Aufgabe und Lösung

Der Erfindung liegt die Aufgabe zugrunde, ein eingangs genanntes Verfahren sowie eine eingangs genannte Vorrichtung zu schaffen, mit denen Probleme des Standes der Technik vermieden werden können und insbesondere eine bessere und effizientere Beschichtung eines genannten Trägers mit Cadmiumsulfid erfolgen kann bei geringerem Verbrauch von Chemie.

Gelöst wird diese Aufgabe durch ein Verfahren mit den Merkmalen des Anspruchs 1 sowie eine Vorrichtung mit den Merkmalen des Anspruchs 14. Vorteilhafte sowie bevorzugtes Ausgestaltungen der Erfindung sind Gegenstand der weiteren Ansprüche und werden im Folgenden näher erläutert. Manche der nachfolgenden Merkmale werden zwar nur für das Verfahren oder die Vorrichtung genannt, sie sollen jedoch unabhängig davon sowohl für das Verfahren als auch für die Vorrichtung gelten bzw. verwendet werden können. Der Wortlaut der Ansprüche wird durch ausdrückliche Bezugnahme zum Inhalt der Beschreibung gemacht. Des weiteren wird der Wortlaut der deutschen Prioritätsanmeldung DE 102007052237.3 vom 22. Oktober 2007 derselben Anmelderin durch ausdrückliche Bezugnahme zum Inhalt der vorliegenden Beschreibung gemacht.

Es ist vorgesehen, dass der Träger an mindestens der zu beschichtenden Absorberschicht mit einer Lösung benetzt wird, aus der Cadmiumsulfid ausgefällt werden soll auf die Absorberschicht. Bevorzugt besteht eine solche Lösung aus Cadmiumacetat, Ammoniak und Thioharnstoff. Entsprechende Zusammensetzungen sind dem Fachmann geläufig.

Erfindungsgemäß wird der Träger in ein Bad mit der Lösung getaucht und im kontinuierlichen oder quasi-kontinuierlichen Transport durch das Bad hindurchgeführt. Zumindest die Absorberschicht ist dabei in dem Bad permanent mit der Lösung benetzt, so dass eine gute Beschichtung mit Cadmiumsulfid möglich ist. Dabei ist die Menge der Lösung in dem Bad relativ klein, was durch einen geringen Lösungsfüllstand erreicht wird. So wird der Verbrauch an Lösung bzw. den darin enthaltenen Chemikalien gering gehalten. Eine Bewegung des Trägers durch das Bad hindurch weist den Vorteil auf, dass eine gewisse Durchmischung der Lösung erfolgt und sozusagen die die Trägeroberfläche benetzende Lösung ausgetauscht wird bzw. nicht immer dieselbe ist.

Vorteilhaft kann der geringe Lösungsfüllstand in dem Bad wenige Millimeter betragen, besonders vorteilhaft 3 bis 20 Millimeter, beispielsweise 5 bis 10 Millimeter. Dabei kann die Lösung bzw. das Bad in einer Wanne vorgesehen sein und diese kann etwas breiter als ein Träger und mehrere Meter lang sein.

In Ausgestaltung der Erfindung wird nicht nur die zu beschichtende Absorberschicht mit der Lösung benetzt, sondern der gesamte Träger in das Bad eingetaucht und hindurchgeführt. Die Benetzungszeit bzw. Tauchzeit sollte einige Minuten betragen, vorteilhaft etwa 10 Minuten. So kann eine Schichtdicke des Cadmiumsulfids von etwa 50nm erreicht werden, was funktional als vorteilhaft angesehen wird.

Der Träger kann vorteilhaft mit einer langsamen Geschwindigkeit durch das Bad hindurch transportiert und dabei kontinuierlich bewegt werden. Dies ist insbesondere dann von Vorteil, wenn als Träger keine plattenartigen Träger verwendet werden, sondern langgestreckte Träger bzw. Folien, die von einer Rolle abgerollt, zur Beschichtung mit Cadmiumsulfid durch das Lösungsbad hindurch geführt und anschließend wieder aufgerollt werden. Die Geschwindigkeit ist dabei bevorzugt so abgestimmt, dass bei einer gewissen Eintauchlänge bzw. Länge des Lösungsbades eine entsprechende Verweildauer erreicht wird für eine ausreichende Beschichtung mit Cadmiumsulfid.

Ein Transport der Träger kann vorteilhaft vor dem Bad und zumindest kurz hinter dem Bad bzw. aus dem Bad heraus höher verlaufen als in dem Bad selbst. So wird ein Einbringen und Ausbringen vereinfacht sowie die Konstruktion einer Wanne mit dem Lösungsbad darin. Ein Träger kann zum Eintauchen in das Bad abgesenkt werden bzw schräg nach unten verlaufen, was bei genannten folienartigen Trägern besonders leicht ist und durch Rollen oder Rollenbahnen realisiert werden kann. Durch das Bad hindurch bewegt sich der Träger vorteilhaft in etwa auf einer Ebene bzw. horizontal. Am Ende des Bades kann er wieder angehoben bzw. schräg laufend aus dem Bad heraus bewegt werden.

Die vorgenannten Rollen können auch in dem Bad vorgesehen sein. Anzahl und Anordnung sind so zu bestimmen, dass der Träger stets in vorteilhafter Lage verläuft, üblicherweise horizontal im Bad.

Ein solcher folienartiger Träger kann sehr dünn sein mit einer Kunststofffolie, beispielsweise mit einer Dicke von etwa 20µm bis 30µm. Seine Länge kann bei einer Breite von einem oder wenigen Metern viele Meter betragen, beispielsweise bis zu mehreren 100 Metern.

Vorteilhaft ist es, wenn der Träger mit der Absorberschicht nach unten in dem Lösungsbad ist bzw. durch dieses hindurchtransportiert wird. So können sich Ablagerungen, insbesondere ausgefälltes Cadmiumsulfid in kleinen Brocken oder Teilen, nicht an der Absorberschicht anlagern, sondern höchstens an der Rückseite. Dort können sie aber nach der Beschichtung leicht wieder entfernt werden, beispielsweise durch leichtes Bürsten, ein Sprühsystem odgl.. Die Rückseite derartiger Träger für Dünnschichtsolarzellen ist meistens zu diesem Zeitpunkt zumindest funktional noch nicht verwendet und deswegen auch mechanisch so robust, dass Abbürsten odgl. gut möglich ist.

In einer Ausgestaltung der Erfindung kann die Lösung im Bad zyklisch erneuert werden. Dabei kann jeweils sämtliche Lösung vollständig abgelassen werden, wenn sie als verbraucht angesehen wird, und durch neue unverbrauchte Lösung ersetzt werden. Ein derartiges Ablassen der sozusagen verbrauchten Lösung kann beispielsweise etwa alle 20 Minuten erfolgen, da sich im Rahmen der Entwicklungsarbeiten zu der vorliegenden Erfindung gezeigt hat, dass dann die Beschichtungsrate stark nachlässt.

In alternativer Ausgestaltung der Erfindung kann die Lösung in dem Bad permanent erneuert werden. Dazu kann ständig ein Teil der Lösung entnommen werden und durch neue unverbrauchte Lösung ersetzt werden. Die Austauschrate kann dabei so sein, dass mindestens alle 20 Minuten die Lösung zumindest theoretisch vollständig ersetzt wird. Bei dieser Ausgestaltung ist der Vorteil gegeben, dass die Lösung eine stets in etwa gleiche Zusammensetzung aufweist und ein Beschichtungsprozess mit stets gleichen Parametern ablaufen kann.

Es ist möglich, die Lösung in dem Bad zu filtern. Vorteilhaft ist bei einer vorbeschriebenen Umwälzung der Lösung, bei der sie aus dem Bad herausgeführt wird, eine permanente Filterung möglich. Beispielsweise kann dabei ausgefälltes Cadmiumsulfid in Form kleiner Teile oder Brocken herausgefiltert werden.

Wie eingangs beschrieben, wird das Bad mit der Lösung bevorzugt erhitzt, um mit der Abscheidung von Cadmiumsulfid zu beginnen. Eine Erhitzung erfolgt vorteilhaft auf eine Temperatur von 50°C bis 65°C, besonders vorteilhaft auf etwa 60°C. Eine Möglichkeit, die Lösung bzw. ein Bad mit der Lösung darin zu erhitzen, besteht darin, dass dieses Bad, beispielsweise mit einer großen flachen Wanne, mit einem aufgeheizten Wasserbad umgeben wird bzw. in einem aufgeheizten Wasserbad angeordnet ist. Somit muss keine Beheizung direkt in der Beschichtungslösung oder an der Außenseite einer genannten Wanne angeordnet werden. Des weiteren ist durch eine Erhitzung in einem Wasserbad eine sehr gleichmäßige und auch kontinuierliche Erhitzung möglich, da Temperaturschwankungen durch die Wärmekapazität des Wassers ausgeglichen werden. Das Wasserbad kann entweder direkt beheizt sein oder aber wiederum mit aufgeheiztem Wasser aus einem Wasservorrat oder einem Wasserbecken gespeist werden. Ein solches Wasserbecken kann unterhalb des Wasserbades samt Wanne mit Lösung angeordnet sein und es an zumindest einer Seite überragen, vorteilhaft an allen Seiten. Dort, wo das Wasserbecken das Wasserbad überragt, kann ein Überlauf vorgesehen sein. So ist es möglich, aus dem Wasserbecken mit einem im Vergleich zum Wasserbad nochmals sehr viel größeren Wasservolumen samt Beheizung aufgeheiztes Wasser in das Wasserbad zu pumpen. Das verdrängte Wasser wird dann über den Überlauf zurück in das Wasserbecken geleitet, so dass ein Art Kreislauf möglich ist.

Für eine kontinuierliche und gleichmäßige Erhitzung der Lösung kann ihre Temperatur vorteilhaft kontinuierlich gemessen werden. Dazu kann ein Temperatursensor in die Lösung hineinragen. Alternativ oder zusätzlich kann die Temperatur des Wasserbades oder des Wasserbeckens gemessen werden und dann so auf einen Wert eingestellt werden, dass die Lösung gewünschte Temperatur aufweist nach Erhitzen durch das Wasserbad.

Zusätzlich kann der Lösungszustand im Bad ständig überprüft werden. Dazu kann ein Füllstandssensor verwendet werden, der in das Bad hineinragt. Dies ist sowohl bei einem kontinuierlichen als auch bei einem Ersetzen der Lösung in Intervallen von Vorteil.

Es empfiehlt sich, die Anlage in gewissen Zeitabständen zu reinigen. Hierzu kann eine säurehaltige Reinigungslösung mit beispielsweise 5% Salzsäure verwendet werden. Diese Reinigungslösung kann in das Bad bzw. eine Wanne für das Bad gegeben werden und mit einer Pumpe einige Zeit lang umgewälzt werden, um das Cadmiumsulfid zu entfernen, welches sich an sämtlichen Flächen der Anlage und Leitungen ablagert. Durch die Umwälzung der Reinigungslösung wird die gesamte Anlage von Cadmiumsulfidablagerungen gesäubert. Abschließend wird die Reinigungslösung abgelassen und entsorgt. Dann kann die Anlage mit Wasser gründlich nachgespült werden, um noch Reste der Reinigungslösung zu entfernen.

Eine Wanne für das Bad besteht vorteilhaft aus Metall, insbesondere um einen guten Wärmeübergang von einem umgebenen Wasserbad zu schaffen. Zur Widerstandsfähigkeit gegen die verwendeten Chemikalien ist die Wanne vorteilhaft mit Titan beschichtet oder kann ganz aus Titan bestehen.

Die Beschichtungsvorrichtung kann ein im Wesentlichen geschlossenes, langgestrecktes Gehäuse aufweisen, in dem die Beschichtung stattfindet. Das Gehäuse kann Einführschleusen und Ausführschleusen für die Träger aufweisen. Der Sinn dieser Schleusen liegt darin, dass durch ein in dem Gehäuse befindliches Wasserbad bzw. erhitztes Wasserbecken die Temperatur in dem Gehäuse einigermaßen gut gehalten wird. Dies spart nicht nur Energie, sondern sorgt auch gleichzeitig für eine entsprechende Vorwärmung der Träger direkt nach dem Einlaufen in das Gehäuse, was die Beschichtung mit Cadmiumsulfid ebenfalls verbessert.

Diese und weitere Merkmale gehen außer aus den Ansprüchen auch aus der Beschreibung und der Zeichnung hervor, wobei die einzelnen Merkmale jeweils für sich allein oder zu mehreren in Form von Unterkombination bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnung

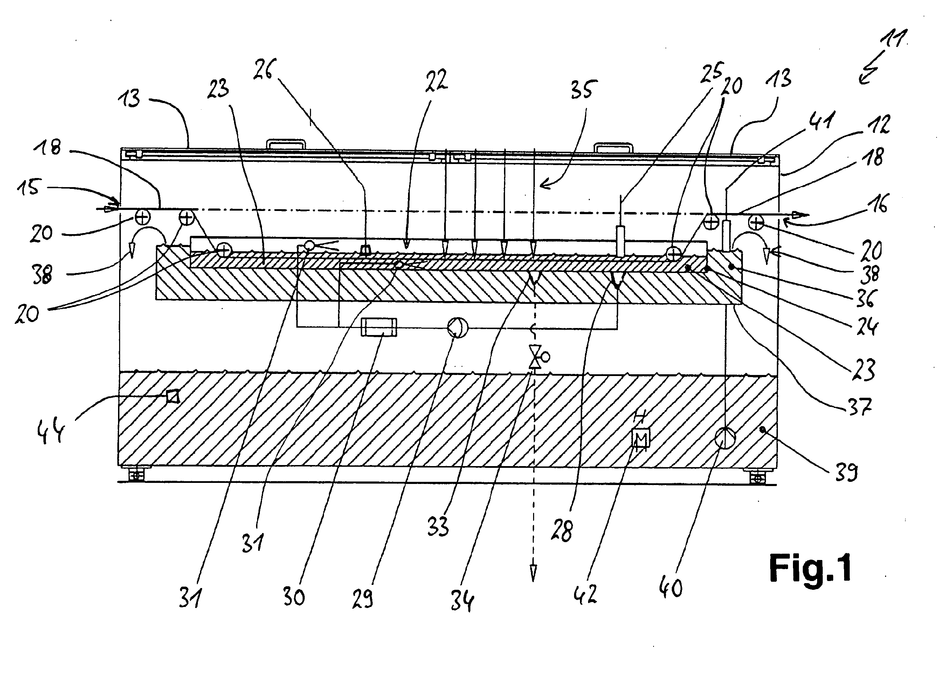

Ein Ausführungsbeispiel der Erfindung ist in der Zeichnung schematisch dargestellt und wird im folgenden näher erläutert. Dabei zeigt die Figur 1 eine schematische Seitenansicht einer erfindungsgemäßen Beschichtungsanlage für folienartige Träger für Dünnschichtsolarzellen, die durch ein flaches Beschichtungsbad hindurchlaufen.

### Detaillierte Beschreibung des Ausführungsbeispiels

In der Figur 1 ist eine erfindungsgemäße Beschichtungsanlage 11 dargestellt mit einem Gehäuse 12, welches an seiner Oberseite Deckelklappen 13 aufweist. Links weist das Gehäuse eine Einschleusung 15 und rechts eine Ausschleusung 16 auf, beispielsweise in Form schmaler Schlitze, unter Umständen mit Vorhängen odgl. versehen. Durch die Einschleusung 15 läuft ein folienartiger Träger 18 auf Rollen 20 links in das Gehäuse 12 hinein und rechts durch die Ausschleusung 16 wieder heraus. Solche folienartigen Träger 18 für Dünnschichtsolarzellen sind dem Fachmann ja bekannt, wie oben erläutert worden ist. Dabei ist eine auf dem Träger 18 bereits vorhandene Absorberschicht samt darauf aufgebrachter Schicht aus Cadmiumtellurid oder einer CIS-Absorberschicht nach unten gerichtet bzw. weist nach unten. Sie kann aber auch nach oben weisen.

Der folienartige Träger 18 läuft also von links in das Gehäuse 12 hinein und wird dann von einer höheren Transportebene, welche strichpunktiert auch im Gehäuse 12 dargestellt ist, mittels der Rollen 20 nach unten umgelenkt in ein Bad 22 mit einer Lösung 23 in einer Wanne 24 des Bades. Die Lösung ist dabei eine vorgenannte Mischung aus Cadmiumacetat, Ammoniak und Thioharnstoff, um daraus nach Erwärmung Cadmiumsulfid auf die Absorberschicht abzuscheiden. Dabei läuft der Träger 18 kontinuierlich und mit sehr geringer Geschwindigkeit durch das Bad 22 mit der Lösung 23. Die Geschwindigkeit kann dabei bei etwa 0,5cm pro Sekunde liegen, sodass sich bei einer Länge von 3 Metern des eingetauchten Trägers eine Verweilzeit von etwa 10 Minuten ergibt. Dadurch erfolgt eine Beschichtung mit Cadmiumsulfid in einer Dicke von etwa 50nm. Für eine Anlage mit größerer Länge würde man mehrere Kammern vorsehen.

Die Wanne 24 für das Bad 22 weist noch einen Füllstandssensor 25 auf sowie einen Temperatursensor 26. Darauf wird nachfolgend noch genauer eingegangen.

Des weiteren ist an der Wanne 24 ein Ablauf 28 vorgesehen, der zu einer Umwälzpumpe 29, einem Filter 30 und mehreren Einströmrohren 31 führt, mit denen entnommene Lösung 23 nach dem Filtern wieder in das Bad 22 zurückgespeist wird. Das Einströmrohr 31 kann, wie dargestellt, über der Lösung 23 oder mitten in der Lösung sein. Dadurch ist zusätzlich eine Verbesserung der Umwälzung der Lösung 23 möglich für ein besseres Beschichtungsergebnis, vor allem hinsichtlich der Beschichtungsqualität als auch etwas hinsichtlich der schnelleren Beschichtung.

Das Bad 22 bzw. dessen Wanne 24 weist außerdem einen Auslass 33 mit Auslassventil 34 auf. Damit kann nach bestimmter Zeit verbrauchte Lösung 23 aus dem Bad 22 abgelassen werden und durch neue ersetzt werden. Alle neuen Zuläufe erfolgen von oben.

Das Bad 22 bzw. die Wanne 24 befindet sich in einem Wasserbad 36 mit einer Wanne 37. Das Wasserbad 36 ist erhitzt und erwärmt so das Bad 22 mit der Lösung 23 auf eine gewünschte Temperatur, die dann mit dem Temperatursensor 26 überwacht werden kann. Allerdings ist ein Überlauf 38 nach links und nach rechts bzw. vorteilhaft an allen Seiten der Wanne 37 vorgesehen. Auslaufendes Wasser aus dem Wasserbad 36 kann dabei in ein unterhalb angeordnetes Wasserbecken 39 laufen, welches nahezu die gesamte Grundfläche des Gehäuses 12 einnimmt. Mittels einer Wasserpumpe 40 wird erhitztes Wasser aus dem Wasserbecken 39 in die Wanne 37 gepumpt und bewirkt so, dass das Wasserbad 36 auf gewünschter Temperatur gehalten wird. Dazu befindet sich in dem Wasserbecken 39 eine Heizung 42 beliebiger Bauart, vorteilhaft natürlich elektrisch. Die Temperatur im Wasserbecken 39 wird durch einen Temperatursensor 44 überwacht, sodass insgesamt eine Temperaturregelung der Lösung 23 auf eine optimale bzw. gewünschte sowohl über den Temperatursensor 26 in der Lösung als auch über den Temperatursensor 44 im Wasserbecken 39 erfolgt. Zusätzlich kann in dem Wasserbad 36 ein Füllstandssensor 41 vorgesehen sein, der den ausreichenden Füllstand im Wasserbad kontrolliert.

Mit der dargestellten Anlage 11 kann erreicht werden, dass die folienartigen Träger 18 für Dünnschichtsolarzellen im Durchlaufbetrieb mit Cadmiumsulfid beschichtet werden. Dabei reicht es, wenn der Füllstand im Bad 22 gering ist, beispielsweise wenige mm beträgt, solange die Unterseite des Trägers 18 benetzt ist bzw. in die Lösung 23 eingetaucht ist. Sollte der folienartige Träger 18 über die Länge des Bades 22 hinweg zu stark durchhängen, so kann anstelle weiterer Rollen 20, welche hier eventuell schlecht wären für eine Beschichtung, ein Anströmen von unten mit weiteren Einströmrohren 31 odgl. verhindert werden. Dabei kann gleichzeitig die Lösung 23 zusätzlich umgewälzt werden. Des weiteren kann mittels Ablauf 28 und Umwälzpumpe 29 ein Umwälzen der Lösung 23 erfolgen. Über den Auslass 33 und das Auslassventil 34 kann ebenfalls zumindest alte bzw. verbrauchte Lösung 23 entfernt werden, deren Menge dann, geregelt durch den Füllstandssensor 25, über den Zulauf wieder ausgeglichen wird.

Die dargestellte Art der Erwärmung des Bades 22 bzw. der Lösung 23 mit dem Wasserbad 36 weist die vorgenannten Vorteile einer sehr gleichmäßigen und gut kontrollierbaren Temperatur auf. Gleichzeitig wird in dem gesamten Gehäuse 12 eine nahe an den 60°C für die Lösung 23 liegende Temperatur erreicht, sodass auch der links durch die Einschleusung 15 einlaufende Träger 18 noch vor dem Eintauchen in das Bad 22 entsprechend vorgewärmt wird. Auch dies ist vorteilhaft für die Beschichtung.

Nach der Ausschleusung 16 kann vorgesehen sein, zumindest die Seite ohne Absorberschicht, also hier die Rückseite, des Trägers 18 von Cadmiumsulfid-Partikeln und Teilchen zu befreien. Dafür können Bürsten, beispielsweise rotierende Spiralbürsten in einem Bürstmodul, vorgesehen sein. Dies kann durch Sprüheinrichtungen unterstützt werden. Vor allem die Absorberseite des Trägers 18, die hier nach unten weist, sollte nur durch Sprühen oder Abspritzen gereinigt werden, unter Umständen geht es auch mit einer sehr weichen Bürste.

Zum vorbeschriebenen Reinigungsvorgang kann, beispielsweise ebenfalls über einen Zulauf, frische Reinigungslösung in das Bad 22 bzw. die Wanne 24 eingelassen werden und mittels der Umwälzpumpe 29 umgewälzt werden. Dabei wird die Anlage von Cadmiumsulfid-Beschichtungen oder anderen Ausfällungen gereinigt. Abschließend kann die Reinigungslösung am Auslass 33 entfernt werden.

Alternativ zu einem dargestellten folienartigen Träger 18 können mit einer derartigen Anlage auch starre oder weniger flexible Träger bzw. Substrate beschichtet werden, beispielsweise aus dünnem Glas odgl.. Anstelle der Umlenkung mittels der Rollen 20 mit relativ großem Winkel kann entweder ein weniger schräges Einfahren der Substrate oder Träger in das Bad 22 erfolgen. Alternativ können sie von links durch eine Einschleusung 15 in das Gehäuse 12 einlaufen und dann von einer Transportebene abgesenkt werden auf eine Rollenbahn odgl. in dem Bad 22, beispielsweise mittels Greifern. Dort werden sie dann in einer vorbestimmten Zeit von links nach rechts durch das Bad transportiert und dann, zum rechten Ende hin, wiederum durch Greifer angehoben und auf der Transportebene durch die Ausschleusung 16 wieder entfernt. Bis auf das Absenken und Anheben der Träger in und aus dem Bad 22 liegt dann auch hier ein kontinuierlicher Transport durch das Bad vor und somit eine kontinuierliche Beschichtung.

## Patentansprüche

1. Verfahren zur Beschichtung eines Trägers (18) bzw. Substrats für Dünnschichtsolarzellen mit Cadmiumsulfid auf eine Absorberschicht auf dem Träger, wobei der Träger an mindestens der zu beschichtenden Absorberschicht mit einer Lösung (23) aus Cadmiumacetat, Ammoniak und Thioharnstoff zur Ausfällung von Cadmiumsulfid benetzt wird, **dadurch gekennzeichnet, dass** der Träger (18) in ein Bad (22) mit der Lösung (23) getaucht wird und im kontinuierlichen Transport durch das Bad hindurchgeführt wird, wobei zumindest die Absorberschicht in dem Bad permanent mit der Lösung benetzt ist und wobei der Lösungsfüllstand in einer Wanne (24) für das Bad (22) mit der Lösung (23) 3 bis 20 Millimeter beträgt.

2. Verfahren nach Anspruch 1, **dadurch gekennzeichnet, dass** der Lösungsfüllstand in einer Wanne (24) für das Bad (22) mit der Lösung (23) 5 bis 10 Millimeter beträgt.

3. Verfahren nach Anspruch 1 oder 2, **dadurch gekennzeichnet, dass** der gesamte Träger (18) durch das Bad (22) eingetaucht hindurchtransportiert wird, wobei er vorzugsweise für 10 Minuten benetzt ist bis zur Bildung einer Schichtdicke von 50nm.

4. Verfahren nach einem der vorhergehenden Ansprüche, **dadurch gekennzeichnet, dass** der Träger (18) mit langsamer Geschwindigkeit durch das Bad (22) transportiert wird, vorzugsweise kontinuierlich.

5. Verfahren nach einem der vorhergehenden Ansprüche, **dadurch gekennzeichnet, dass** die Transportebene des Trägers (18) vor dem Bad (22) auf einem höheren Niveau ist als durch das Bad, wobei der Träger abgesenkt wird in das Bad hinein und am Ende des Bades (22) wieder herausbewegt und angehoben werden zum Transport weg von dem Bad auf einer wiederum höheren Transportebene.

6. Verfahren nach einem der vorhergehenden Ansprüche, **dadurch gekennzeichnet, dass** ein Träger (18) flexibel bzw. dünn ist, vorzugsweise folienartig, wobei insbesondere ein folienartiger Träger (18) eine sehr große Länge im Vergleich zu seiner Breite aufweist mit einer Länge, die diejenige des Bades (22) um ein Vielfaches übertrifft.

7. Verfahren nach einem der vorhergehenden Ansprüche, **dadurch gekennzeichnet, dass** ein Träger (18) mit der Absorberschicht nach unten im Wesentlichen horizontal liegend durch das Bad (22) mit der Lösung (23) transportiert wird.

8. Verfahren nach einem der Ansprüche 1 bis 6, **dadurch gekennzeichnet, dass** ein Träger (18) mit der Absorberschicht nach oben im Wesentlichen horizontal liegend durch das Bad (22) mit der Lösung (23) transportiert wird.

9. Verfahren nach einem der vorhergehenden Ansprüche, **dadurch gekennzeichnet, dass** die Lösung (23) in dem Bad (22) bewegt bzw. umgewälzt wird, wobei dazu insbesondere eine Umwälzpumpe (29), ein Einströmrohr (31) vorgesehen ist.

10. Verfahren nach einem der vorhergehenden Ansprüche, **dadurch gekennzeichnet, dass** die Lösung (23) im Bad (22) zyklisch erneuert wird durch vollständiges Ablassen verbrauchter Lösung und Ersetzen mit neuer, unverbrauchter Lösung, wobei insbesondere ein vollständiges Ablassen alle 20 Minuten erfolgt.

11. Verfahren nach einem der vorhergehenden Ansprüche, **dadurch gekennzeichnet, dass** das Bad (22) mit der Lösung (23) erhitzt wird, vorzugsweise auf eine Temperatur von 50°C bis 65°C, wobei insbesondere das Bad (22) mit der Lösung (23) dadurch erhitzt wird, dass es sich in einer Wanne (24) befindet und diese Wanne mit einem aufgeheizten Wasserbad (36, 37) umgeben wird bzw. in dem Wasserbad angeordnet ist, wobei vorzugsweise das Wasserbad mit aufgeheiztem Wasser aus einem darunter liegenden Wasserbecken (39) gespeist wird, das das darüber liegende Wasserbad (36, 37) samt Wanne (24) mit Lösung (23) darin an allen Seiten überragt, wobei das Wasserbad einen Überlauf (38) aufweist in das darunterliegende Wasserbecken (39).

12. Verfahren nach einem der vorhergehenden Ansprüche, **dadurch gekennzeichnet, dass** die Temperatur der Lösung (23) gemessen wird, vorteilhaft kontinuierlich, wobei insbesondere auch die Temperatur eines Wasserbads (36, 37) und/oder eines darunter liegenden Wasserbeckens (39) gemessen und entsprechend nachgeregelt wird auf einen gewünschten Temperaturwert der Lösung.

13. Verfahren nach einem der vorhergehenden Ansprüche, **dadurch gekennzeichnet, dass** zur Reinigung einer Anlage (11) eine säurehaltige Reinigungslösung, vorzugsweise fünfprozentige Salzsäurelösung, in das Bad (22) gegeben wird und mit einer Pumpe (29) für einige Zeit umgewälzt wird und dabei das Bad bzw. eine Wanne (24) für das Bad (22) sowie Rohrleitungen benetzt und reinigt, wobei abschließend die Reinigungslösung abgelassen wird und mit Wasser nachgespült wird zum Entfernen von Resten der Reinigungslösung.

14. Vorrichtung zur Durchführung des Verfahrens nach einem der vorhergehenden Ansprüche, wobei eine Beschichtungsanlage (11) ein flaches Becken (24) als Bad (22) zur Aufnahme der Lösung (23) aufweist mit Rollen (20) bzw. Rollenbahnen darin zum Transport des Trägers (18) durch das Bad, **dadurch gekennzeichnet, dass** die Transportebene des Trägers (18) vor dem Bad (22) auf einem höheren Niveau ist als durch das Bad, wobei der Träger abgesenkt in das Bad hinein läuft und am Ende des Bades (22) wieder herausbewegt und angehoben laufen zum Transport weg von dem Bad auf einer wiederum höheren Transportebene, und, dass der Lösungsfüllstand in einer Wanne (24) für das Bad (22) mit der Lösung (23) 3 bis 20 Millimeter beträgt.

15. Vorrichtung nach Anspruch 14, **dadurch gekennzeichnet, dass** sie ein im Wesentlichen geschlossenes Gehäuse (12) aufweist, welches Einführschleusen (15) und Ausführschleusen (16) für den Träger (18) aufweist.

16. Vorrichtung nach einem der Ansprüche 14 oder 15, **gekennzeichnet durch** eine Heizeinrichtung (42) für die Lösung (23) in dem Bad (22), insbesondere zum Erhitzen des Bades mit der Lösung in einer Wanne (24), wobei diese Wanne in einem aufgeheizten Wasserbad (36, 37) angeordnet ist, wobei vorzugsweise unter dem Wasserbad ein darunter liegendes Wasserbecken (39) mit aufgeheiztem Wasser angeordnet ist zur Speisung des Wasserbades, wobei insbesondere das Wasserbecken (39) das darüber liegende Wasserbad (36, 37) samt Wanne (24) mit Lösung (23) darin an allen Seiten überragt und wobei vorzugsweise das Wasserbad einen Überlauf (38) aufweist in das darunter liegende Wasserbecken (39).

## Claims

1. A method for coating a carrier (18) or substrate for thin-film solar cells with cadmium sulfide onto an absorber layer on the carrier, wherein the carrier, at least at the absorber layer to be coated, is wetted with a solution (23) composed of cadmium acetate, ammonia and thiourea for the precipitation of cadmium sulfide, **characterized in that** the carrier (18) is dipped into a bath (22) with the solution (23) and is guided in continuous transport through the bath, wherein at least the absorber layer is permanently wetted with the solution in the bath, and wherein the solution filling level in a tub (24) for the bath (22) with the solution (23) is 3 to 20 millimeters.

2. The method as claimed in claim 1, **characterized in that** the solution filling level in a tub (24) for the bath (22) with the solution (23) is 5 to 10 millimeters.

3. The method as claimed in claim 1 or 2, **characterized in that** the entire carrier (18) is transported through the bath (22) in an immersed fashion, wherein said carrier is preferably wetted for 10 minutes until a layer thickness of 50 nm is formed.

4. The method as claimed in any of the preceding claims, **characterized in that** the carrier (18) is transported through the bath (22) at a slow speed, preferably continuously.

5. The method as claimed in any of the preceding claims, **characterized in that** the transport plane of the carrier (18) upstream of the bath (22) is at a higher level than through the bath, wherein the carrier is lowered into the bath and is moved out and raised again at the end of the bath (22) for transport away from the bath on a once again higher transport plane.

6. The method as claimed in any of the preceding claims, **characterized in that** a carrier (18) is flexible or thin, preferably film-like, wherein in particular a film-like carrier (18) has a very large length in comparison to its width, with a length which exceeds that of the bath (22) by a multiple.

7. The method as claimed in any of the preceding claims, **characterized in that** a carrier (18) is transported with the absorber layer downward in a manner lying substantially horizontally through the bath (22) with the solution (23).

8. The method as claimed in any of the claims 1 to 6, **characterized in that** a carrier (18) is transported with the absorber layer upward in a manner lying substantially horizontally through the bath (22) with the solution (23).

9. The method as claimed in any of the preceding claims, **characterized in that** the solution (23) is moved or circulated in the bath (22), wherein in particular a circulating pump (29), an inflow pipe (31) is provided for this purpose.

10. The method as claimed in any of the preceding claims, **characterized in that** the solution (23) in the bath (22) is cyclically renewed by complete draining of spent solution and replacement by new, unused solution, wherein in particular complete draining is effected every 20 minutes.

11. The method as claimed in any of the preceding claims, **characterized in that** the bath (22) with the solution (23) is heated, preferably to a temperature of 50°C to 65°C, wherein in particular the bath (22) with the solution (23) is heated by virtue of the fact that it is situated in a tub (24) and said tub is surrounded by a heated water bath (36, 37) or is arranged in the water bath, wherein preferably the water bath is supplied with heated water from an underlying water tank (39), which projects beyond the overlying water bath (36, 37) together with tub (24) with solution (23) therein on all sides, wherein the water bath has an overflow (38) into the underlying water tank (39).

12. The method as claimed in any of the preceding claims, **characterized in that** the temperature of the solution (23) is measured, advantageously continuously, wherein in particular the temperature of a water bath (36, 37) and/or of an underlying water tank (39) is also measured and correspondingly readjusted to a desired temperature value of the solution.

13. The method as claimed in any of the preceding claims, **characterized in that**, for cleaning an installation (11) an acid-containing cleaning solution, preferably five percent hydrochloric acid solution, is passed into the bath (22) and circulated for a time by means of a pump (29) and in the process wets and cleans the bath and/or a tub (24) for the bath (22) and also pipelines, wherein finally, the cleaning solution is drained and rinsing with water is subsequently effected in order to remove residues of the cleaning solution.

14. A device for carrying out the method as claimed in any of the preceding claims, wherein a coating installation (11) has a flat tank (24) as bath (22) for receiving the solution (23) with rollers (20) or roller conveyors therein for transporting the carrier (18) through the bath, **characterized in that** the transport plane of the carrier (18) upstream of the bath (22) is at a higher level than through the bath, wherein the carrier is lowered into the bath and is moved out and raised again at the end of the bath (22) for transport away from the bath on a once again higher transport plane, and **in that** the solution filling level in a tub (24) for the bath (22) with the solution (23) is 3 to 20 millimeters.

15. The device as claimed in claim 14, **characterized in that** it has a substantially closed housing (12) having introduction locks (15) and discharge locks (16) for the carrier (18).

16. The device as claimed in any of claims 14 or 15, **characterized by** a heating unit (42) for the solution (23) in the bath (22), in particular for heating the bath with the solution in a tub (24), wherein said tub is arranged in a heated water bath (36, 37), wherein an underlying water tank (39) with heated water is preferably arranged under the water bath in order to supply the water bath, wherein in particular the water tank (39) projects beyond the overlying water bath (36, 37) together with tub (24) with solution (23) therein on all sides, and wherein the water bath preferably has an overflow (38) into the underlying water tank (39).

## Revendications

1. Procédé pour le revêtement d'un support (18) ou encore d'un substrat pour cellules solaires en couches minces avec du sulfure de cadmium sur une couche d'absorption sur un support, sachant que le support est mouillé au moins à la couche d'absorption, qui doit être recouverte d'une couche, par une solution (23) d'acétate de cadmium, d'ammoniac et de thiocarbamide pour la précipitation du sulfure de cadmium, **caractérisé en ce que** le support (18) est plongé dans un bain (22) de solution (23) et passé à travers le bain par transport continu, sachant qu'au moins la couche d'absorption est mouillée de manière permanente dans le bain contenant la solution et sachant que le niveau de remplissage de solution dans une cuve (24) pour le bain (22) contenant la solution (23) comporte de 3 à 20 millimètres.

2. Procédé d'après la revendication 1, **caractérisé en ce que** le niveau de remplissage de solution dans une cuve (24) pour le bain (22) contenant la solution (23) comporte de 5, à 10 millimètre.

3. Procédé d'après la revendication 1 ou 2, **caractérisé en ce que** tout le support (18) est transporté à travers le bain (22) de manière immergée, sachant qu'il est mouillé de préférence pendant 10 minutes jusqu'à la formation d'une épaisseur de couche d'à peu près 50 nm.

4. Procédé d'après une des revendications précédentes, **caractérisé en ce que** le support (18) est transporté à faible vitesse à travers le bain (22), de préférence de manière continue.

5. Procédé d'après une des revendications précédentes, **caractérisé en ce que** le plan de transport du support (18) avant le bain (22) se situe à un niveau plus haut que pendant la traversée du bain, sachant que le support entre dans le bain en étant baissé et qu'à la fin du bain (22) il est ensuite sorti et remonté pour un transport d'éloignement du bain sur un plan de transport à nouveau plus haut.

6. Procédé d'après une des revendications précédentes, **caractérisé en ce qu'**un support (18) est flexible ou encore mince, de préférence du genre pellicule, sachant que notamment un support (18) du type pellicule présente une très grande longueur par rapport à sa largeur, avec une longueur qui dépasse d'un multiple celle du bain (22).

7. Procédé d'après une des revendications précédentes, **caractérisé en ce qu'**un support (18) avec la couche d'absorption orientée vers le bas est transporté à travers le bain (22) contenant la solution (23) essentiellement en étant couché en position horizontale.

8. Procédé d'après une des revendications de 1 à 6, **caractérisé en ce qu'**un support (18) avec la couche d'absorption orientée vers le haut est transporté à travers le bain (22) contenant la solution (23) essentiellement en étant couché en position horizontale.

9. Procédé d'après une des revendications précédentes, **caractérisé en ce qu'**on fait bouger ou encore circuler la solution (23) dans le bain (22), sachant qu'à ce but on prévoit notamment une pompe de circulation (29), un tuyau d'admission (31).

10. Procédé d'après une des revendications précédentes, **caractérisé en ce que** la solution (23) dans le bain (22) est périodiquement renouvelée en évacuant entièrement la solution épuisée et en la remplaçant par une nouvelle solution non épuisée, sachant qu'une évacuation totale a notamment lieu toutes les 20 minutes.

11. Procédé d'après une des revendications précédentes, **caractérisé en ce que** le bain (22) contenant la solution (23) est chauffée, de préférence à une température de 50°C jusqu'à 65°C, sachant que notamment le bain (22) contenant la solution (23) est chauffé par le fait qu'il se trouve dans une cuve (24) et que cette cuve est entourée d'un bain-marie chauffé (36, 37) ou encore qu'elle est disposée dans le bain-marie, sachant que de préférence le bain-marie est alimenté en eau chauffée par un bassin d'eau (39) situé au-dessous de celui-ci, qui dépasse le bain-marie (36, 37) situé au-dessus y compris la cuve (24) contenant la solution (23) en hauteur de tous les côtés, sachant que le bain-marie présente un déversoir ou trop-plein (38) vers le bassin d'eau (39) sous-jacent.

12. Procédé d'après une des revendications précédentes, **caractérisé en ce que** la température de la solution (23) est mesurée, de préférence continuellement, sachant que notamment la température d'un bain-marie (36, 37) et/ou d'un bassin d'eau (39) situé au-dessous est également mesurée et ajustée en conséquence à une valeur de température de solution souhaitée.

13. Procédé d'après une des revendications précédentes, **caractérisé en ce que** pour le nettoyage d'une installation (11) on introduit dans le bain (22) une solution de nettoyage acide, de préférence une solution d'acide chlorhydrique à cinq pourcent qu'on fait circuler pendant un certain temps au moyen d'une pompe (29) et qui ainsi mouille et nettoie le bain ou encore une cuve (24) pour le bain (22) ainsi que les conduites, sachant qu'en conclusion on fait sortir la solution de nettoyage et on rince à l'eau pour éliminer des restes de solution de nettoyage.

14. Dispositif pour la mise en oeuvre du procédé d'après une des revendications précédentes, pour lequel une installation pour le revêtement (11) présente un bassin peu profond (24) en tant que bain (22) pour le logement de la solution (23) avec à l'intérieur des rouleaux (20) ou encore des transporteurs à rouleaux pour le transport du support (18) à travers le bain, **caractérisé en ce que** le plan de transport du support (18) avant le bain (22) se situe à un niveau plus haut que pendant la traversée du bain, sachant que le support entre dans le bain en étant baissé et qu'à la fin du bain (22) il est ensuite sorti et se déplace en étant remonté pour un transport d'éloignement du bain sur un plan de transport à nouveau plus haut, et **en ce que** le niveau de remplissage de solution dans une cuve (24) pour le bain (22) contenant la solution (23) comporte de 3 à 20 millimètres.

15. Dispositif d'après la revendication 14, **caractérisé en ce qu'**il présente un boîtier (12) essentiellement fermé, qui présente des sas d'introduction (15) et des sas d'évacuation (16) pour le support (18).

16. Dispositif d'après une des revendications 14 ou 15, **caractérisé par** un moyen de chauffage (42) pour la solution (23) dans le bain (22), notamment pour le chauffage du bain avec la solution dans une cuve (24), sachant que cette cuve est disposée dans un bain-marie (36, 37) chauffé, sachant que de préférence au-dessous du bain-marie est disposé un bassin d'eau (39) sous-jacent avec de l'eau chauffée pour l'alimentation du bain-marie, sachant que notamment le bassin d'eau (39) dépasse en hauteur de tous les côtés le bain-marie (36, 37) y compris la cuve (24) avec à l'intérieur la solution (23) et sachant que de préférence le bain-marie présente un trop-plein (38) vers le bassin d'eau (39) sous-jacent.
